# EUROPEAN PATENT SPECIFICATION

(11) **EP 0 809 286 B1**
(45) Date of publication and mention of the grant of the patent: **01.10.2003**
(21) Application number: 96830280.2
(22) Date of filing: 14.05.1996
(51) Int. Cl.: H01L 21/8249, H01L 21/74

(54) **A process for the fabrication of semiconductor devices having various buried regions**
Verfahren zur Herstellung von Halbleiterbauteilen mit verschiedenartigen vergrabenen Dotierungsgebieten
Procédé de manufacture de dispositifs semi-conducteurs ayant des régions profondes variées

(43) Date of publication of application: 26.11.1997
(73) Proprietor: STMicroelectronics S.r.l., 20041 Agrate Brianza (Milano) (IT)
(72) Inventor: Palmieri, Michele, 20019 Settimo Milanese (IT); Galbiati, Paola, 20052 Monza (Milano) (IT); Vecchi, Lodovica, 20052 Monza (Milano) (IT)
(74) Representative: Maggioni, Claudio

(56) References cited:
- EP-A- 0 032 550
- EP-A- 0 339 637
- US-A- 5 110 749
- US-A- 5 330 922
- IBM TECHNICAL DISCLOSURE BULLETIN, vol. 29, no. 1, June 1986, NEW YORK US, pages 258-259, XP002013355 "Field-Defined Bipolar Structure in CMOS Technology"

## Description

The present invention relates to processes for the production of semiconductor devices and more particularly to a process of the type defined in Claim 1.

various techniques are known for producing a wide variety of electronic components in the same silicon wafer, having very different geometries and functional characteristics. These techniques produce integrated devices comprising circuits for processing both digital and analogue signals operating with CMOS field-effect transistors or low power bipolar transistors, and circuits for. the control of external loads comprising both field-effect and bipolar transistors.

Devices of this general type require structures comprising various buried regions, that is to say regions entirely immersed in the silicon, which are different both in conductivity type, that is to say of N-type or P-type, and in resistivity, that is to say having higher or lower concentrations of impurities. These regions are often called buried layers, especially when their thickness is very much less than their lateral extent.

A known process for the formation of buried layers is disclosed in US-A-5 110 749. Another know process for the formation of three different buried layers is described in detail hereinbelow. As will be seen, this known process requires a separate masking operation for the formation of each buried layer. Each of these operations takes place over various phases which require repeated manipulations and stresses of the silicon wafer in which a large number of integrated devices are to be formed. Since each of these phases contributes to an increase in the risk of breakage of the wafer and to introduce into the structure being worked defects which lower the production yield, a reduction in the number of masking operations is desirable.

The present invention makes available a process, as is characterised in Claim 1, which not only satisfies this requirement but furthermore provides the designer with greater range of choices in the formation of the buried regions.

The invention will be better understood from the following detailed description of an embodiment in relation to the attached drawings, in which:
Figures 1 to 6 are sections which show a part of a silicon chip in various successive fabrication stages of a known process; and
Figures 7 to 10 are sections which show a part of a silicon chip in various successive fabrication stages of the process according to the invention.

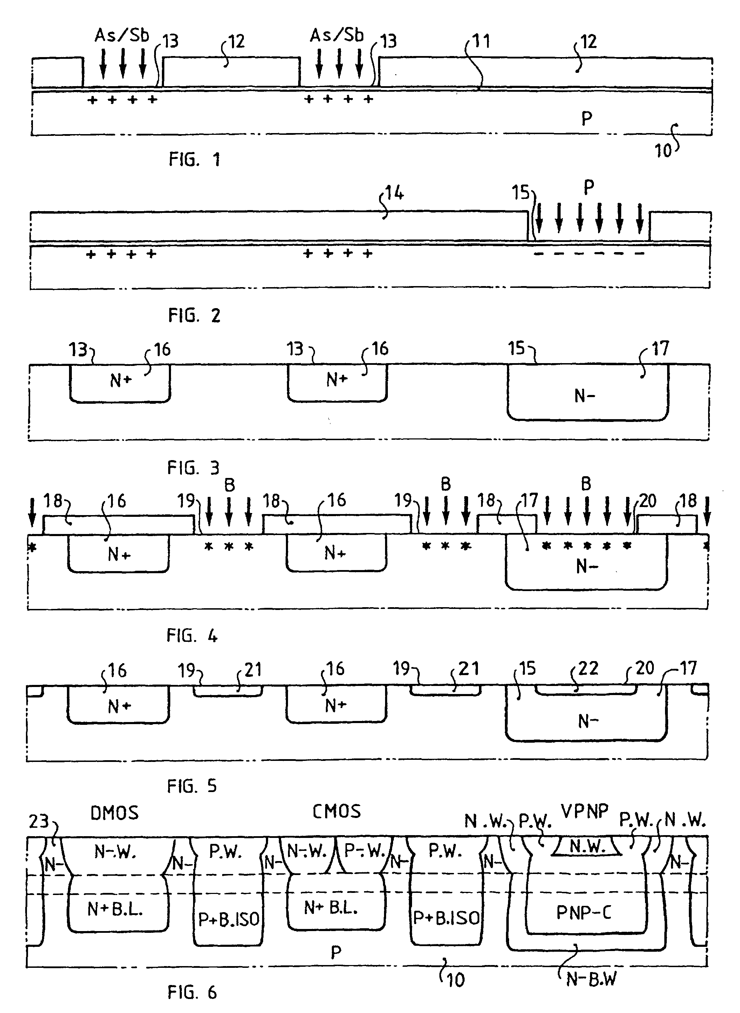

With reference first to Figure 1, on a substrate of monocrystaline silicon, indicated 10, of P-type conductivity a thin layer 11 (20- 30 nm) of silicon dioxide is grown at high temperature. On this layer is formed a mask 12 of "resist" with the usual photolithographic techniques, in such a way as to define windows over several surface regions (two in Figure 1, both indicated 13). The thus-masked substrate is subjected to an operation of implantation with ions of arsenic and antimony (As/Sb) in high doses (at least 10¹⁵ cm⁻²) with an energy lying between 60 and 100 KeV. The ions are blocked by the resist layer but easily traverse the thin layer of oxide 11 which, as is known, has the function of preventing the surface of the monocrystaline silicon from being subject to damage to its superficial crystalline structure by the effect of implantation. In the silicon, under the exposed surface regions 13, form implanted regions of strongly doped N-type indicated with a series of + signs.

The resist mask 12 is then removed and another one formed, indicated 14 (Figure 2) which defines apertures on other surface regions, there being only one in the drawing indicated 15. With a further implantation operation, this time with ions of phosphorus (P) in moderate doses, that is to say lying between 5 x 10¹³ and 5 x 10¹⁴ cm⁻², and with an energy lying between 60 and 200 KeV, under the exposed surface regions 15 form moderately doped N-type implanted regions indicated with a series of - signs.

After removal of the mask 14 the substrate is heated to a high temperature (1100-1200°C) for a time sufficient to allow the implanted ions to diffuse to a predetermined depth as is shown in Figure 3. They thus form, at the surface regions 13, regions 16 of strongly doped N conductivity type, therefore indicated N+, intended to constitute the buried layers of several integrated components such as DMOS transistors and pairs of complementary CMOS transistors (Figure 6) and, at the surface regions 15, regions 17 of moderately doped N conductivity type, thus indicated N-, intended to constitute buried layers which delimit wells for containment of other integrated components, for example vertical PNP transistors VPNP (Figure 6).

There is then formed a third mask of resist, indicated 18 in Figure 4, which defines windows on surface areas indicated 19, of the substrate, which separate from one another the regions intended to contain separate components, and windows on surface areas of the substrate, only one indicated 20 shown in Figure 4, within the surface area of the region 17. The thus-masked substrate is then subjected to implantation with boron ions (B) in doses lying between 1 x 10¹⁴ and 1 x 10¹⁵ cm⁻² with an energy lying between 25 and 200 KeV in such a way as to form strongly doped P-type implanted regions indicated with a series of * signs.

The third mask 18 is then removed and the substrate heated to a temperature (500-600°C) such as to allow a preliminary diffusion (annealing) of the implanted boron ions as is shown in Figure 5, where P-type regions indicated 21 in the surface areas 19, and 22 in the surface area 20, are shown.

The process proceeds with the formation of an epitaxial layer 23 of N conductivity type by growing at high temperature on the monocrystaline silicon substrate 10. This operation, in this example, takes place in two phases and is accompanied by various selective doping and diffusion operations. A structure such as that shown in Figure 6 is thus obtained. In this structure three types of buried regions can be recognised, formed by the effect of the above-described operations, that is to say the buried layers N+ indicated N+B.L, which originated from the regions 16, the buried layer N-, indicated N-B.L, which originated from the region 17 and the deep insulation regions P+, indicated P+B.ISO which originate from the regions 21. These buried regions form by diffusion both in the substrate 10 and in the parts of the epitaxial layer 23 which form in the first epitaxial growth phase.

In the example shown in Figure 6, in the part of the epitaxial layer 23 overlying one buried layer N+B.L is formed an N region, indicated N-W intended to contain a DMOS transistor. In another part of the epitaxial layer 23 overlying another buried layer N+B.L are formed both another N region, again indicated N-W and a P region, indicated P-W, intended to contain, respectively, a P channel MOS transistor and an N channel MOS transistor of a pair of CMOS transistors. Within the buried layer N-B.L forms, by diffusion from the region 22 (Figure 5) a P region indicated PNP-C in Figure 6, which also extends into part of the epitaxial layer formed in the first growth phase. Above the buried layer N-B.L, in the epitaxial layer 23, is formed an N region, indicated N.W, intended to complement the insulation well of a vertical PNP transistor VPNP. Within this region N.W is formed a P region indicated P.W, intended to constitute a region of deep contact with the collector region PNP-C of the vertical PNP transistor. Similar P regions, also indicated P.W, are formed above the regions P+B.ISO and join with these to insulate the various components of the integrated device from one another.

The structure is then subjected to further operations, well known to those skilled in the art, to obtain a complete electronic device.

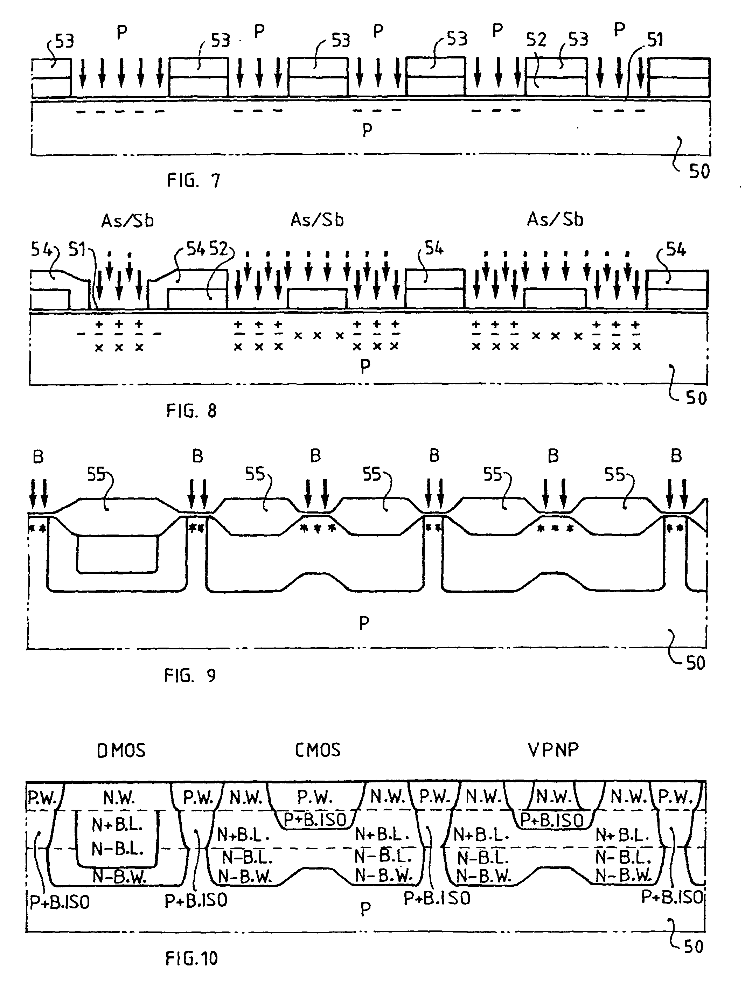

The process according to the invention is now described with reference to Figures from 7 to 10. On a monocrystaline silicon substrate of P conductivity type, indicated 50, is formed by growing at high temperature a thin layer 51 of silicon dioxide the function of which is that already explained in relation to the known process and which is not indispensable to put the process according to the invention into practice. On the thin layer 51 is deposited a layer of silicon nitride 52 of thickness lying between 60 and 120 nm. On this layer is then formed a mask 53 of resist in such a way as to cover some surface areas of the nitride layer leaving others thereof exposed. A chemical attack removes the nitride from the exposed areas and the substrate 50 with the thus-formed nitride and resist mask is subjected to an implantation of ions of doping impurity of N-type, in this case phosphorus (P) with relatively low doses (1-5 x 10¹³ cm⁻²) and with an energy lying between 25 and 200 KeV. Under the surface areas of the silicon substrate left exposed by the nitride mask that is to say covered only by the thin layer of silicon dioxide 51, form implanted regions of lightly doped N-type indicated with a series of - signs in Figure 7.

The resist which covers the nitride is then removed and another resist mask, indicated 54 (Figure 8) is formed, the thickness of which is such as to be impermeable to subsequent ion implantations. This mask covers some of the areas of the substrate left exposed by the nitride mask, and parts of the nitride mask.

The thus-masked substrate is subjected to a first implantation operation with ions of N-type doping impurity, in this case doping at low diffusivity such as arsenic and antimony (As/Sb) with a relatively high dose (10¹⁵-10¹⁶ cm⁻²) and an energy value chosen in such a way that the ions do not succeed in traversing the parts of the nitride mask 52, whether or not they are covered by the resist mask 53, but succeed in implanting into the substrate zone covered only by the thin oxide layer 51. There are thus formed implanted N-type regions doped more heavily than the previously implanted N regions and indicated in Figure 8 with a series of + signs.

With the same mask a second implantation operation then proceeds with ions of N-type doping impurity, in this case again with ions of As/Sb in moderate doses (5 x 10¹³-5 x 10¹⁴ cm⁻²) and with a sufficiently high energy (200-500 KeV) as to traverse the parts of the nitride mask not covered by the resist mask 54. The N regions previously implanted with As/Sb ions are thereby further doped and new regions of N-type form in the substrate 50 under the parts of the nitride mask not covered by resist. This is represented by a series of x signs. It is noted that the order of the two implantation operations can be reversed obtaining substantially the same results.

After having removed the resist mask 54 the substrate covered by the nitride mask is subjected to a high temperature treatment (1100-1200°C) in an oxidising environment for a time (1-3 hours) sufficient to form relatively thick pads (300-1000 nm) of silicon dioxide, indicated 55, on the areas of the substrate not covered by the nitride and to make the previously-implanted impurities diffuse into the substrate 50. As is known to the man skilled in the art, since the silicon dioxide grows at the expense of the underlying silicon, at the end of the treatment the pads are partly embedded in the substrate.

The nitride mask 52 is then removed and the structure subjected to a third implantation operation, this time with doping impurities of opposite type from those of the preceding implantations. In this example boron is utilised in doses of a value chosen between 1 x 10¹⁵ and 1 x 10¹⁵ cm⁻² and at low energy (25-50 KeV). The oxide pads 55 constitute a barrier to implantation so that the ions penetrate only in the areas of the substrate between the pads forming P-conductivity regions indicated with a series of * signs in Figure 9. The structure is then subjected to a short heat treatment (annealing) and the process then proceeds with the removal of the oxide pads 55, the formation of an epitaxial layer and various selective doping operations in the same way as briefly described with reference to the known process to obtain the structure shown in Figure 10.

As is seen, four types of buried regions can be recognised in the structure, formed by the above-described operations, that is to say the buried N+ layers, indicated N+B.L, which originate from the regions indicated with the + signs in Figure 8, the buried N-wells, indicated N-B.W which originate from the regions indicated with the - signs in Figures 7 and 8, and buried N- layers indicated N-B.L, which originate from the regions indicated with x signs in Figure 8 and the deep insulation regions P+, indicated P+B.ISO, which originate from the regions indicated with * signs in Figure 9. These buried regions form, as already indicated above in relation to the known process, by diffusion both into the substrate 50 and into the epitaxial layer.

With this example of the process according to the invention is obtained a structure which, like the structure of Figure 6 obtained with the known process, is intended to contain a DMOS transistor, a CMOS pair and a vertical PNP transistor VPNP. As distinct from the structure of Figure 6, the DMOS transistor has a buried well of N-type less doped at its edges so that it is able to support higher voltages, the CMOS pair has a P-type well formed in part by a buried region P+B.ISO obtained with the same formation operations as the deep insulation regions, and an N-type well with variable distribution of concentrations of the impurities particularly favourable to a good insulation against the adjacent P+ regions and to an optimum immunity to the phenomenon known as "latch up" due to the formation of a parasitic thyristor. A similar N-type well effectively insulates the vertical PNP transistor.

In this case, too, the structure is then subjected to further treatments known to the man skilled in the art in order to obtain a complete electronic device.

From a comparison with the known process it can be recognised that, to obtain the three buried regions, that is to say the buried strongly doped N-type layer (N+B.L) the P-type deep insulation region (P+B.ISO) and the moderately doped N-type buried layer (N-B.W) with the known process three resist masks are necessary (12, Figure 1; 14, Figure 2 and 18, Figure 4) whilst with the process according to the invention two such masks are sufficient, that is to say that indicated 53 in Figure 7 which also serves for the definition of the silicon nitride layer 52, and that indicated 54 in Figure 8. This constitutes a considerable simplification of the process and thus an advantage in terms of overall yield. It is also recognised that the process according to the invention makes available a further buried layer that is to say the moderately doped buried layer indicated N-B.W, which constitutes a real advantage in terms of design versatility.

The process according to the invention also allows a significant advantage in terms of saving of area. In fact, the buried insulation region (P+B.ISO) is self-aligned with the buried N-type regions (N+B.L and N-B.W) so that there is no loss of area due to the necessity of taking into account the alignment tolerances of the masks as in the known process. An area saving also arises for another reason. With the known process, in order to obtain an effective insulation of the buried N-type regions it is necessary that the buried P-type insulation regions be spaced from these in such a way as to leave lightly doped silicon, that is to say that of the substrate or of the epitaxial layer, between regions to be insulated and insulating regions. Therefore it is necessary that the resist mask 18 in Figure 4 extends for a certain extent beyond the edges of the regions 16 and 17. With the process according to the invention this requirement does not exist because the quality of the insulation is optimised by using lower concentrations of doping impurities for the buried N-type regions of those devices which must support higher voltages. This is made possible by the fact that according to the invention there is available a further implantation phase to obtain buried lightly doped N-type regions (N-B.W)

## Claims

1. A process for the fabrication of an integrated semiconductor device on a substrate (50) of monocrystaline silicon of a first conductivity type (P) which comprises the following operations:
introducing into the substrate doping impurities of a first (B) and a second (P, As/Sb) type through first and second areas, respectively, of a major surface of the substrate,
subjecting the substrate (50) to epitaxial growth at high temperature to form on its major surface an epitaxial layer which delimits with the substrate buried regions of the first type (P) of conductivity and a second type (N) of conductivity opposite the first, by diffusion of the impurities introduced into the substrate in the previous operation and
selectively doping the epitaxial layer in such a way as to form in it a multiplicity of regions of first (P) and second (N) conductivity type,
and whereby the operation of introducing doping impurities of the first (B) and second (P, As/Sb) type into the substrate comprises the following successive steps:
forming a mask (52) of silicon nitride on the major surface of the substrate, which leaves areas of the substrate exposed,
introducing doping impurities of the second type (P) through the areas left exposed by the silicon nitride mask,
forming a mask ( 54 ) of a material impermeable to the implantation of ions which leaves at least one area of the substrate containing a part of the silicon nitride mask (52) exposed,
performing either one of a first and second ion implantations the first implantation comprising implanting doping impurities of the second type (As/Sb) with an energy insufficient to traverse the said part of the silicon nitride mask but sufficient to introduce ions into the substrate (50) through the remaining part of the said at least one area of the substrate containing a part of the silicon nitride mask (52), and the second ion implantation with comprising implanting doping impurities of the second type (As/Sb) with an energy sufficient to traverse the said part of the silicon nitride mask in such a way as to introduce ions into the substrate (50) through the whole of the said at least one area of the substrate containing a part of the silicon nitride mask (52),
performing the other one of said first and second ion implantations,
removing the mask (54) impermeable to the implantation,
subjecting the substrate (50) to a high temperature treatment in an oxidising environment to form pads (55) of silicon dioxide on the areas of the substrate not covered by the silicon nitride mask,
removing the silicon nitride mask (52) to expose areas of the substrate delimited by the pads (55),
performing a third ion implantation of doping impurities of the first type (B) with an energy insufficient to traverse the silicon dioxide pads (55) but sufficient to introduce ions into the areas of the substrate delimited by the pads and
removing the silicon dioxide pads (55).

2. A process according to Claim 1, in which the first implantation is performed before the second implantation.

3. A process according to Claim 1, in which the first implantation is performed after the second implantation.

4. A process according to any preceding claim, in which before the operation of introducing doping impurities of the first type.and of the second type into the substrate there is formed a thin layer of silicon dioxide on the major surface of the substrate, which is removed before the epitaxial growth operation.

5. A process according to any preceding claim, in which the formation of a silicon nitride mask (52) comprises the formation of a layer (53) of material impermeable to ion implantation over a layer of silicon nitride.

## Patentansprüche

1. Ein Verfahren zur Herstellung eines integrierten Halbleiterbauelements auf einem Substrat (50) aus monokristallinem Silizium eines ersten Leitfähigkeitstyps (P), das die folgenden Operationen aufweist:
Einbringen von Dotierungsverunreinigungen eines ersten (B) und eines zweiten (P, As/Sb) Typs in das Substrat durch einen ersten beziehungsweise einen zweiten Bereich einer Hauptoberfläche des Substrats,
Unterziehen des Substrats (50) einem epitaxialen Aufwachsen bei hoher Temperatur, um durch eine Diffusion der Verunreinigungen, die bei der vorhergehenden Operation in das Substrat eingebracht wurden, auf der Hauptoberfläche desselben eine Epitaxialschicht zu bilden, die mit dem Substrat vergrabene Gebiete des ersten Leitfähigkeitstyps (P) und eines zweiten Leitfähigkeitstyps (N), der dem ersten entgegengesetzt ist, begrenzt, und
selektives Dotieren der Epitaxialschicht in einer derartigen Weise, um in derselben eine Menge von Gebieten des ersten (P) und des zweiten (N) Leitfähigkeitstyps zu bilden,
und wobei die Operation des Einbringens von Dotierungsverunreinigungen des ersten (B) und des zweiten (P, As/Sb) Typs in das Substrat die folgenden aufeinanderfolgenden Schritte aufweist:
Bilden einer Maske (52) aus Siliziumnitrid auf der Hauptoberfläche des Substrats, die Bereiche des Substrats freiliegend läßt,
Einbringen von Dotierungsverunreinigungen des zweiten Typs (P) durch die Bereiche, die durch die Siliziumnitridmaske freiliegend gelassen sind,
Bilden einer Maske (54) aus einem für die Implantation von Ionen undurchlässigen Material, die zumindest einen Bereich des Substrats freiliegend läßt, der einen Teil der Siliziumnitridmaske (52) enthält,
Durchführen von entweder einer ersten oder einer zweiten Ionenimplantation, wobei die erste Implantation ein Implantieren von Dotierungsverunreinigungen des zweiten Typs (As/Sb) mit einer Energie aufweist, die nicht ausreichend ist, um den Teil der Siliziumnitridmaske zu durchlaufen, aber ausreichend ist, um Ionen in das Substrat (50) durch den verbleibenden Teil des zumindest einen Bereichs des Substrats einzubringen, der einen Teil der Siliziumnitridmaske (52) enthält, und wobei die zweite Ionenimplantation ein Implantieren von Dotierungsverunreinigungen des zweiten Typs (As/Sb) mit einer Energie aufweist, die ausreichend ist, um den Teil der Siliziumnitridmaske in einer derartigen Weise zu durchlaufen, um Ionen in das Substrat (50) durch den ganzen zumindest einen Bereich des Substrats einzubringen, der einen Teil der Siliziumnitridmaske (52) enthält,
Durchführen der anderen der ersten und zweiten Ionenimplantation,
Entfernen der für die Implantation undurchlässigen Maske (54),
Unterziehen des Substrats (50) einer Hochtemperaturbehandlung in einer oxidierenden Umgebung, um auf den Bereichen des Substrats, die nicht durch die Siliziumnitridmaske bedeckt sind, Anschlußflächen (55) aus Siliziumdioxid zu bilden,
Entfernen der Siliziumnitridmaske (52), um Bereiche des Substrats freizulegen, die durch die Anschlußflächen (55) begrenzt sind,
Durchführen einer dritten Ionenimplantation von Dotierungsverunreinigungen des ersten Typs (B) mit einer Energie, die nicht ausreichend ist, um die Siliziumdioxid-Anschlußflächen (55) zu durchlaufen, aber ausreichend ist, um Ionen in die Bereiche des Substrats einzubringen, die durch die Anschlußflächen begrenzt sind, und
Entfernen der Siliziumdioxid-Anschlußflächen (55).

2. Ein Verfahren gemäß Anspruch 1, bei dem die erste Implantation vor der zweiten Implantation durchgeführt wird.

3. Ein Verfahren gemäß Anspruch 1, bei dem die erste Implantation nach der zweiten Implantation durchgeführt wird.

4. Ein Verfahren gemäß einem der vorhergehenden Ansprüche, bei dem vor der Operation des Einführens von Dotierungsverunreinigungen des ersten Typs und des zweiten Typs in das Substrat eine Dünnschicht aus Siliziumdioxid auf der Hauptoberfläche des Substrats gebildet wird, die vor der Operation des epitaxialen Anwachsens entfernt wird.

5. Ein Verfahren gemäß einem der vorhergehenden Ansprüche, bei dem die Bildung einer Siliziumnitridmaske (52) die Bildung einer Schicht (53) aus einem für eine Ionenimplantation undurchlässigen Material über einer Schicht aus Siliziumnitrid aufweist.

## Revendications

1. Procédé de fabrication d'un dispositif à semiconducteur intégré à la surface d'un substrat (50) fait de silicium monocristallin ayant un premier type de conductivité (P), lequel comprend les opérations suivantes :
- introduire dans le substrat des impuretés de dopage d'un premier type (B) et d'un second type (P, As/Sb) à travers une première zone et une seconde zone, respectivement, d'une surface principale du substrat ;
- soumettre le substrat (50) à une croissance épitaxiale à haute température de manière à former sur sa surface principale une couche épitaxiale qui délimite les régions enfouies du substrat ayant le premier type de conductivité (P) et un second type de conductivité (N) opposé au premier, ceci par diffusion des impuretés introduites dans le substrat lors de l'opération précédente ; et
- doper sélectivement la couche épitaxiale de manière à former dans celle-ci de multiples régions ayant le premier type de conductivité. (P) et le second type de conductivité (N) ;
laquelle opération d'introduction d'impuretés de dopage d'un premier type (B) et d'un second type (P, As/Sb) dans le substrat comprend les étapes suivantes :
- former un masque (52) de nitriure de silicium sur la surface principale du substrat, qui laisse des zones du substrat exposées ;
- introduire les impuretés de dopage du second type (P) à travers les zones laissées exposées par le masque en nitriure de silicium ;
- former un masque (54) d'un matériau imperméable à l'implantation d'ions, qui laisse au moins une zone du substrat contenant une partie du masque en nitriure de silicium exposée ;
- effectuer l'une ou l'autre d'une implantation d'un premier type ou d'une implantation d'un second type, l'implantation du premier type consistant à implanter des impuretés dopantes du second groupe (As/Sb) avec une énergie insuffisante pour traverser ladite partie du masque en nitriure de silicium mais suffisante pour introduire des ions dans le substrat (50) à travers la partie restante de ladite et au moins une zone du substrat contenant une partie du masque en nitriure de silicium (52), tandis que la seconde implantation d'ions consiste à implanter des impuretés de dopage du second type (As/Sb) avec une énergie suffisante pour traverser ladite partie du masque en nitriure de silicium de manière à introduire des ions dans le substrat (50) à travers ladite et au moins une zone toute entière du subtrat contenant une partie du masque en nitriure de silicium (52) ;
- effectuer l'autre implantation d'ions parmi l'implantation d'ions du premier type et l'implantation d'ions du second type ;
- retirer le masque (54) imperméable à l'implantation ;
- soumettre le substrat (50) à un traitement à haute température dans un environnement oxydant afin de former des plaques (55) de dioxyde de silicium sur les zones du substrat non couvertes par le masque en nitriure de silicium ;
- retirer le masque en nitriure de silicium (52) afin d'exposer les zones du substrat délimitées par les plaques (55) ;
- effectuer une troisième implantation ionique d'impuretés dopantes du premier type (B) avec une énergie insuffisante pour traverser les plaques de dioxyde de silicium (55) mais suffisante pour introduire des ions dans les zones du substrat délimitées par les plaques ; et
- retirer les plaques de dioxyde de silicium (55).

2. Processus, selon la revendication 1, dans lequel l'implantation du premier est effectuée avant l'implantation du second type. .

3. Processus, selon la revendication 1, dans lequel l'implantation du premier est effectuée après l'implantation du second type.

4. Processus, selon l'une quelconque des revendications précédentes, dans lequel, avant l'opération d'introduction d'impuretés dopantes du premier type et du second type dans le substrat, on forme une couche fine de dioxyde de silicium sur la surface principale du substrat, laquelle est retirée avant l'opération de croissance épitaxiale.

5. Processus, selon l'une quelconque des revendications précédentes, dans lequel la formation du masque en nitriure de silicium (52) consiste à former une couche (53) d'un matériau imperméable à l'implantation d'ions sur une couche de nitriure de silicium.
